# EUROPÄISCHE PATENTANMELDUNG

(11) **EP 1 154 277 A1**
(43) Veröffentlichungstag der Anmeldung: **14.11.2001**
(21) Anmeldenummer: 00109737.7
(22) Anmeldetag: 08.05.2000
(51) Int. Cl.: G01R 15/20

(54) **Vorrichtung zum Messen elektrischer Stromstärken**

(71) Anmelder: Infineon Technologies AG, 81669 München (DE)
(72) Erfinder: Köck, Gerd, Dipl.-Ing., 71254 Ditzingen (DE); Hufgard, Erich, Dipl.-Phys., 93049 Regensburg (DE)
(74) Vertreter: Zimmermann & Partner

(57) **Zusammenfassung**

Um den Strom führenden Leiter (1), der mit einem Hall-Sensor (3) versehen ist, befindet sich eine Abschirmung (2) für das Magnetfeld, die einen quer zu der Längsrichtung des Leiters verlaufenden Querschnitt aufweist, dessen Form zumindest zu dem Leiter hin durch ein Vieleck begrenzt ist, vorzugsweise beidseitig durch zwei verschieden große, zueinander ähnliche und konzentrisch zueinander angeordnet Vielecke begrenzt ist.

## Beschreibung

Die vorliegende Erfindung betrifft eine Vorrichtung zum Messen von Stromstärken, die insbesondere zum Messen hoher Ströme bei großer Genauigkeit geeignet ist.

Insbesondere in der zukünftigen Automobiltechnik wird ein effizientes Batterie- und Energiemanagement gefordert, zu dem auch die Messung hoher Ströme im Bereich von typisch 500 A mit einer Auflösung von 1 A und der Genauigkeit unterhalb 3% gehört. Die Folgefrequenz der Messungen beträgt typisch 25 kHz; die Messung soll im Temperaturbereich von -40°C bis +150°C möglich sein. Eine derartige Strommessung wird bisher auf die Weise durchgeführt, dass der den Strom führende Leiter an einer Stelle U-förmig gebogen wird. In den Schenkeln dieses U wird ein Hall-Sensor zur Strommessung angebracht.

Ein solcher Hall-Sensor beruht auf dem Hall-Effekt. Dieser Effekt tritt auf, wenn sich Elektronen in einem Leiter durch ein Magnetfeld bewegen und die Lorentz-Kraft, die in dem Magnetfeld infolge der Relativgeschwindigkeit der Elektronen zu dem Magnetfeld auftritt, auf diese Elektronen einwirkt. Infolge der Lorentz-Kraft werden die Elektronen, die den Leiter bei Abwesenheit eines Magnetfeldes geradlinig durchlaufen, senkrecht zur Stromrichtung und zur Richtung der Magnetfeldlinien abgelenkt. Als Folge davon stellt sich in dem Leiter, in dem die Elektronen geführt werden, an zwei gegenüberliegenden Seiten quer zur Stromrichtung eine unterschiedliche Elektronenkonzentration ein; dadurch entsteht eine Querspannung, die man als (elektrische) Hall-Spannung bezeichnet. Wird die Größe dieser Hall-Spannung gemessen, kann bei Kenntnis der Stärke des Magnetfeldes auf die Stromstärke rückgeschlossen werden. Eine Anordnung mit einem Leiter in einem Magnetfeld bekannter Stärke kann daher durch Abgreifen der Hall-Spannung als Meßgerät zum Messen der Stromstärke verwendet werden. Ist die Stromstärke bekannt, kann über eine Messung der Hall-Spannung die Stärke des Magnetfeldes bestimmt werden. Wird so die Stärke eines von einem Strom in einem Leiter hervorgerufenen Magnetfeldes, das den Leiter umgibt, an einer definierten Stelle gemessen, kann auf die Stärke des in dem Leiter fließenden Stromes rückgeschlossen werden. Zur Messung der Stromstärke genügt es daher, in der Nähe des Leiters einen von einem Strom bekannter Stärke durchflossenen Leiter anzubringen, an dem eine Hall-Spannung abgegriffen und gemessen wird. Ein derartiger Hall-Sensor ist an sich bekannt.

In einer Leiterschleife ist das Magnetfeld, das von dem Strom in dem Leiter erzeugt wird, bei gleichem Abstand von dem Leiter größer als längs eines geraden Abschnittes des Leiters. Um bei der Messung das Magnetfeld in der U-förmigen Leiterschleife gegen äußere Störmagnetfelder abzuschirmen, wird um den Leiter eine Abschirmung angebracht. Diese Abschirmung ist nahe liegender Weise ein Hohlzylinder.

Aufgabe der vorliegenden Erfindung ist es, eine Vorrichtung zum Messen elektrischer Stromstärken der eingangs beschriebenen Art anzugeben, deren Wirkungsgrad gegenüber herkömmlichen derartigen Vorrichtungen deutlich erhöht ist.

Diese Aufgabe wird mit der Vorrichtung mit den Merkmalen des Anspruchs 1 gelöst. Ausgestaltungen ergeben sich aus den abhängigen Ansprüchen.

Die erfindungsgemäße Vorrichtung vergrößert das von einem Sensor (vorzugsweise einem Hall-Sensor) zur Bestimmung des Magnetfeldes eines stromdurchflossenen Leiters gelieferte Signal deutlich und verbessert damit die Anwendbarkeit derartiger Stromsensoren erheblich. Das wird dadurch bewirkt, dass um den Strom führenden Leiter eine Abschirmung des Magnetfeldes angeordnet ist, die nicht wie herkömmlich einen quer zu der Längsrichtung des Leiters verlaufenden kreisringförmigen Querschnitt aufweist, sondern einen Querschnitt, dessen Form zumindest zu dem Leiter hin durch ein Vieleck begrenzt ist. Vorzugsweise sind dessen Seiten geradlinig berandet; die Seiten können aber auch gekrümmt sein. Vorzugsweise wird der besagte Querschnitt durch zwei verschieden große Vielecke begrenzt, die zueinander ähnlich und konzentrisch zueinander angeordnet sind, insbesondere durch Sechsecke oder Achtecke. Diese Vielecke besitzen vorzugsweise mindestens eine, aber höchstens endlich viele Symmetrieachsen.

Es folgt eine genauere Beschreibung von Beispielen der erfindungsgemäßen Vorrichtung anhand der Figuren 1 bis 3.
Figur 1 zeigt eine Schnittansicht einer typischen erfindungsgemäßen Vorrichtung.
Figuren 2 und 3 zeigen schematische Darstellungen für mögliche Formen der erfindungsgemäß eingesetzten Abschirmung.

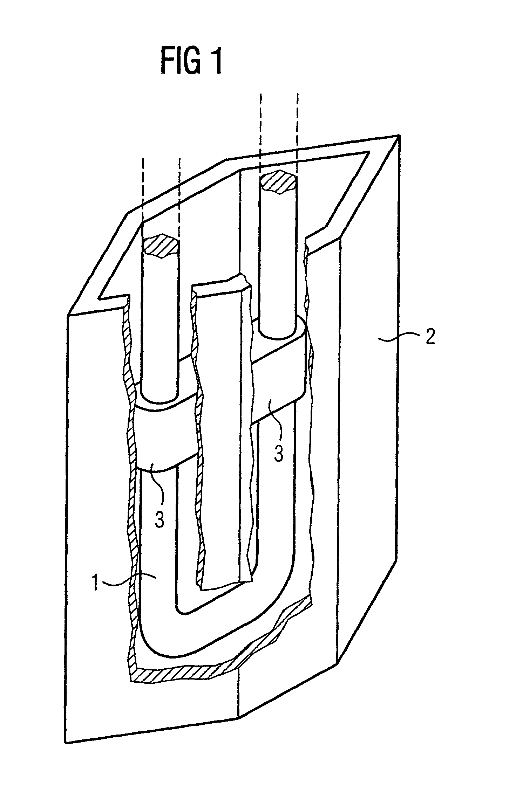

In Figur 1 ist eine erfindungsgemäße Vorrichtung in einer schrägen Ansicht dargestellt, bei der in der Abschirmung 2 an zwei dem Betrachter zugewandten Seiten ein U-förmiger Ausschnitt vorhanden ist, dessen Begrenzungen durch Bruchlinien angedeutet sind. Im Inneren der Abschirmung 2 ist der U-förmig geknickte Leiter 1 angeordnet, der für die Stromführung des zu messenden Stromes vorgesehen ist. Ein Hall-Sensor 3, dessen Ausgestaltung an sich bekannt und im Hinblick auf die vorliegende Erfindung im Prinzip beliebig ist, ist durch eine kastenartig die Leiterschenkel umfassende Einrichtung angedeutet. Grundsätzlich kann hier auch ein auf einer anderen physikalischen Wirkung beruhender Sensor zur Bestimmung der Stärke des den Leiter umgebenden Magnetfeldes eingesetzt werden.

Wie anhand dieser Darstellung der Figur 1 erkennbar ist, besitzt die Abschirmung 2 in diesem Beispiel einen quer zur Längsrichtung des Leiters 1 sechseckig geformten Querschnitt. Dieser Querschnitt wird durch die Außenwände und Innenwände der Abschirmung 2 gebildet. Die Form des Querschnittes ist daher gegeben durch zwei konzentrisch zueinander angeordnete, zueinander ähnliche Sechsecke. Hierbei ist unter der Ähnlichkeit der geometrischen Figuren zu verstehen, dass die Winkel zwischen einander entsprechenden Strecken gleich sind, so dass die Längenverhältnisse einander entsprechender Strecken für beide Figuren gleich sind. Statt eines Kreisringes ist der Querschnitt hier sozusagen durch einen Sechseckring gebildet.

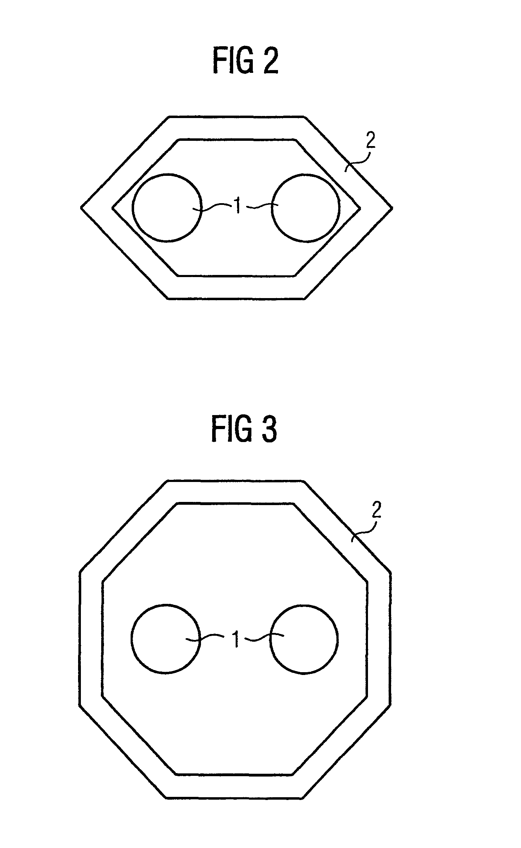

Das wird anhand der Figur 2 nochmals erläutert, in der der Einfachheit halber nur der in diesem Beispiel jeweils kreisrunde Querschnitt der Leiter 1 in der Abschirmung 2 dargestellt ist. Hier ist deutlich erkennbar, dass der Querschnitt der Abschirmung 2 durch zwei konzentrisch zueinander angeordnete, zueinander ähnliche und unterschiedlich große Sechsecke gebildet ist. In diesem Beispiel weisen die Sechsecke zwei Symmetrieachsen auf, was aber keine Bedingung ist. Bei einer Ausgestaltung mit einem regelmäßigen Sechseck besitzt der Querschnitt sechs Symmetrieachsen. Die Seiten der Sechsecke können geradlinig oder gekrümmt sein. Wesentlich für die Vorrichtung ist vorrangig die Formgebung der Innenwände der Abschirmung, so dass die äußere Begrenzung des in der Figur 2 dargestellten Querschnittes bei weniger bevorzugten Ausführungsformen eine von einem Sechseck abweichende Form besitzen kann.

Eine alternative Ausgestaltung ergibt sich gemäß Figur 3 mit einem oktagonalen Querschnitt. Die Innenwände und Außenwände der Abschirmung 2 bilden hier zwei zueinander ähnliche, verschieden große Achtecke, die in dem besagten Querschnitt konzentrisch zueinander angeordnet sind und in dem dargestellten Beispiel regelmäßig sind und acht Symmetrieachsen aufweisen. Wenn die Abschirmung eine bevorzugte oktagonale Form hat, kann das am Hall-Sensor resultierende Magnetfeld, wie Rechnungen gezeigt haben, um einen Faktor > 1,28 gesteigert werden. Damit ist das sich ergebende Messsignal gegenüber herkömmlichen Anordnungen wesentlich vergrößert. Somit ist die erfindungsgemäße Vorrichtung geeignet, mit großer Genauigkeit auch hohe Stromstärken im Bereich um 500 A mit einer Genauigkeit von weniger als 3% vom Endwert zu messen. Auch für den achteckigen Querschnitt kommen weniger bevorzugte Ausführungsformen mit geringerer Symmetrie oder einer abweichenden Form der äußeren Begrenzung in Frage.

## Patentansprüche

1. Vorrichtung zum Messen elektrischer Stromstärken, bei der
- ein elektrischer Leiter (1) vorhanden ist, der für einen zu messenden Strom vorgesehen ist,
- rings um den Leiter (1) eine Abschirmung (2) für ein Magnetfeld vorhanden ist und
- ein Sensor (3) zur Bestimmung der Stärke des Magnetfeldes innerhalb der Abschirmung (2) an dem Leiter (1) angebracht ist,
**dadurch gekennzeichnet, dass**
die Abschirmung (2) einen quer zu einer Längsrichtung des Leiters verlaufenden Querschnitt aufweist, dessen Form zumindest zu dem Leiter hin durch ein Vieleck begrenzt ist.

2. Vorrichtung nach Anspruch 1, bei der
die Abschirmung (2) einen quer zu der Längsrichtung des Leiters verlaufenden Querschnitt aufweist, dessen Form durch zwei konzentrische und zueinander ähnliche Vielecke begrenzt ist.

3. Vorrichtung nach Anspruch 1 oder 2, bei der
der besagte Querschnitt der Abschirmung (2) durch mindestens ein Sechseck begrenzt ist.

4. Vorrichtung nach Anspruch 1 oder 2, bei der
der besagte Querschnitt der Abschirmung (2) durch mindestens ein Achteck begrenzt ist.

5. Vorrichtung nach einem der Ansprüche 1 bis 4, bei der der besagte Querschnitt mindestens eine Symmetrieachse und höchstens endlich viele Symmetrieachsen aufweist.

6. Vorrichtung nach einem der Ansprüche 1 bis 5, bei der der Sensor ein Hall-Sensor (3) zur Messung einer auf Grund des Hall-Effektes durch ein Magnetfeld hervorgerufenen Hall-Spannung ist.
